# EUROPEAN PATENT APPLICATION

(11) **EP 4 386 391 A1**
(43) Date of publication of application: **19.06.2024**
(21) Application number: 22213265.6
(22) Date of filing: 13.12.2022
(51) Int. Cl.: G01R 15/18, H01F 27/36, H01F 38/30, H02H 1/00, H02H 1/06, G01R 1/18

(54) **CURRENT DETECTOR AND POWER HARVESTER WITH INTERPOSED MAGNETIC SHIELDS FOR LOW-VOLTAGE SWITCHES**

(71) Applicant: ABB S.p.A., 20124 Milano (IT)
(72) Inventor: Tomasini, Marco, I-24010 Sorisole (BG) (IT); Gallo, Paolo, 24020 Torre Boldone (BG) (IT)
(74) Representative: De Bortoli, Eros

(57) **Abstract**

An accessory device (1) for a low-voltage switch, which comprises:
- a power supply arrangement (2) for providing a power supply to feed an electronic device onboard said switch, said power supply arrangement including a magnetic core (20), which forms a first magnetic circuit configured to be enchained with a primary winding conductor (150), and a first secondary winding conductor (32), which is wound around said magnetic core;
- a current detection arrangement (3) for providing detection signals indicative of a current flowing along said primary conductor.

The magnetic core of said power supply arrangement and said current detection arrangement are arranged next to each other.

Said accessory device comprises one or more magnetic shield elements (4 - 9), which are interposed between said magnetic core and said current detection arrangement .

## Description

The present invention relates to the field of electrical installations, preferably operating at low-voltage levels. More particularly, the present invention relates to an accessory device for low-voltage switches, which are adapted to measure electrical currents and feed electronic devices incorporated in said low-voltage switches.

As is known, an electrical installation (e.g. an electric grid, an electric switchgear system, an electric switchboard, and the like) normally comprises a number of switches (e.g. circuit breakers, disconnectors, contactors, and the like) designed to allow or prevent the flow of electric currents along corresponding electric lines. Typically, many switches include onboard electronic devices (e.g the so-called "protection relays") designed to carry out control functionalities (e.g. controlling the intervention of the switch in the event of faults or overloads) and/or monitoring functionalities (e.g. providing data sets related to measurements of physical quantities). In order to carry out most of their functionalities, these electronic devices need to collect and process detection signals indicative of electric currents flowing along the electric lines of the electrical installation, on which the switches are arranged.

In order to allow the onboard electronic devices to operate, low voltage switches generally incorporate one or more accessory devices configured to measure electric currents along corresponding electric lines and, at the same time, to harvest electric power from said electric lines in order to feed said electronic devices.

Patent document US2005/0141159A1 discloses an example of accessory device of this type, which is designed for a low-voltage unipolar or multipolar circuit breaker.

The accessory device comprises a suitable amperometric transformer providing a power supply to feed an electronic protection device on board the circuit breaker. The amperometric transformer is arranged in combination with a current detection device designed to provide detection signals indicative of the current flowing along a conductor. Such a current detection device (which may be configured as a Rogowski coil) is positioned in proximity of the magnetic circuit of the amperometric transformer to obtain an overall compact structure.

Accessory devices of the type disclosed in the above-mentioned patent document provide relevant advantages in terms of performances, structural integration and size reduction. However, they show some drawbacks, in particular for what concerning their current measurement performances.

As a matter of fact, the accuracy of the current measurements carried out by the currently available accessory devices is highly variable with the magnitude of the current flowing along the conductors under detection. In particular, it has been seen that these current measurements are affected by relatively high errors (e.g. about the 0,5%) for current rates relatively far from the foreseen nominal current values.

As it easy to understand, such a circumstance is often unacceptable for the management of modern electrical installations, where high precision measurements of physical quantities are generally required.

The main aim of the present invention is to provide an accessory device for low-voltage switches, which allows the above-mentioned drawbacks to be overcome or mitigated.

Within this aim, a purpose of the present invention is to provide an accessory device capable of suitably feeding an electronic device installed on board to a switch and, at the same time, capable of ensuring high-level performances in measuring the current flowing along an electrical conductor included in or operatively associated to the switch.

Another purpose of the present invention is to provide an accessory device, which has a relatively simple and compact structure and can be manufactured industrially at competitive costs.

In order to fulfill these aim and objects, the present invention provides an accessory device, according to the following claim 1 and the related dependent claims.

In a general definition, the accessory device of the invention comprises, in combination, a power supply arrangement adapted to provide a power supply to feed an electronic device on board a switch and a current detection arrangement adapted to measure electrical currents along a conductor associated thereto.

The power supply arrangement includes a magnetic core, which forms a first magnetic circuit configured to be enchained with a primary winding conductor, and a first secondary winding conductor, which is wound around said magnetic core.

The current detection arrangement is adapted to provide detection signals indicative of a current flowing along the aforesaid primary conductor.

Preferably, the current detection arrangement provides said detection signals to the aforesaid electronic device on board the switch.

The magnetic core of the power supply arrangement and the current detection arrangement are arranged next to each other.

According to the invention, the accessory device comprises one or more magnetic shield elements interposed, at least partially, between the magnetic core of the power supply arrangement and the current detection arrangement.

According to an aspect of the invention, the aforesaid current detection arrangement includes a non-magnetic core, which forms a second magnetic circuit configured to be enchained with said primary winding conductor, and at least a second secondary winding conductor, which is wound around said non-magnetic core.

Preferably, the magnetic core of the power supply arrangement and the non-magnetic core of the current detection arrangement are arranged next to each other.

According to this aspect of the invention, the above-mentioned one or more magnetic shield elements are interposed, at least partially, between said magnetic core and said non-magnetic core.

Preferably, the magnetic core of the power supply arrangement and the non-magnetic core of the current detection arrangement comprises respectively a first portion of magnetic core and a second portion of non-magnetic core, which are arranged next to each other. In this case, the above-mentioned one or more magnetic shield elements are interposed, at least partially, between said first portion of magnetic core and said second portion of non-magnetic core.

Preferably, the first portion of the magnetic core of the power supply arrangement and the second portion of the non-magnetic core of the current detection arrangement have matching shapes. More preferably, they are shaped as ring portions with a same radius of curvature.

According to an embodiment of the invention, the accessory device includes a single magnetic shield element made of magnetic material.

Said single magnetic shield element is interposed, at least partially, between the magnetic core of said power supply arrangement and said current detection arrangement (preferably the non-magnetic core of said current detection arrangement).

Preferably, said single magnetic shield element is made of ferromagnetic material.

According to an embodiment of the invention, the accessory device includes a pair of magnetic shield elements arranged next to each other and interposed, at least partially, between the magnetic core of said power supply arrangement and said current detection arrangement (preferably the non-magnetic core of said current detection arrangement).

In particular, a first magnetic shield element made of non-magnetic material is arranged in proximal position to the magnetic core of the power supply arrangement and a second magnetic shield element made of magnetic material is arranged in proximal position to the current detection arrangement (preferably to the non-magnetic core of said current detection arrangement).

Preferably, said first magnetic shield element is made of plastic or silicone material while said second magnetic shield element is made of ferromagnetic material. According to an embodiment of the invention, the accessory device includes three magnetic shield elements arranged next to each other and interposed, at least partially, between the magnetic core of the power supply arrangement and the current detection arrangement (preferably the non-magnetic core of said current detection arrangement).

In particular, a third magnetic shield element and a fourth magnetic shield element both made of magnetic material are arranged in proximal position respectively to the magnetic core of the power supply arrangement and to the current detection arrangement (preferably to the non-magnetic core of said current detection arrangement). A fifth magnetic shield element made of non-magnetic material is interposed, at least partially, between said third and fourth magnetic shield elements. Preferably, said third and fourth magnetic shield elements are made of ferromagnetic material while said fifth magnetic shield element is made of plastic or silicone material.

Preferably, said one or more magnetic shield elements have shapes partially matching with the shape the first portion of the magnetic core of the power supply arrangement and the shape of the second portion of the non-magnetic core of the current detection arrangement.

Preferably, said one or more magnetic shield elements have a ring shape, more preferably ring shapes having the same radius of curvature of the first portion of the magnetic core of the power supply arrangement and the shape of the second portion of the non-magnetic core of the current detection arrangement.

In a further aspect, the present invention relates to a low-voltage switch, according to the following claim 12.

For a better understanding of the present invention, reference is made to the accompanying drawings and to the detailed description hereinafter, in which preferred but non-limitative embodiments of the differential pressure transmitter according to the present invention are illustrated. In the drawings:
- Figure 1 schematically shows a low-voltage switch incorporating an accessory device, according to the invention, for each electric phase;
- Figure 2 schematically shows an outer view of the accessory device, according to the invention;
- Figures 3-4 schematically show partial views of first embodiment of the accessory device, according to the invention;
- Figures 5-7 schematically show partial views of second embodiment of the accessory device, according to the invention;
- Figures 8-10 schematically show partial views of third embodiment of the accessory device, according to the invention;
- Figure 11 schematically shows graphs indicative of the accuracy of the current measurements provided by the accessory device of the invention (according to each of the above-mentioned embodiments) compared to the current measurements provided by an accessory device of the state of the art.

With reference to the aforesaid figures, the present invention relates to an accessory device 1 particularly adapted for use in low-voltage electrical installations, e.g. electric grids, electric switchgear systems, electric switchboards, and the like.

For the purposes of the present invention, the term "low voltage" (LV) relates to operating voltages generally lower than 2 kV AC and 2.5 kV DC.

In general terms, the accessory device 1 is operatively couplable to a conductor 150 and it is configured to harvest electric power from such an electric conductor to provide a suitable power supply for an electronic device 110 installed on board a switch 100 of an electrical installation. In addition, the accessory device 1 is configured to provide detection signals indicative of the current flowing along the conductor 150.

The switch 100 may be a circuit-breaker, a contactor, a disconnector, and the like, while the electronic device 110 may be a solenoid, a protection relay, an IED (Intelligent Electronic Device), and the like.

The conductor 150 may be any conductor included in or operatively associated to the switch 100, e.g. a phase conductor of the switch.

The accessory device 1 is particularly adapted for installation on-board the switch 100.

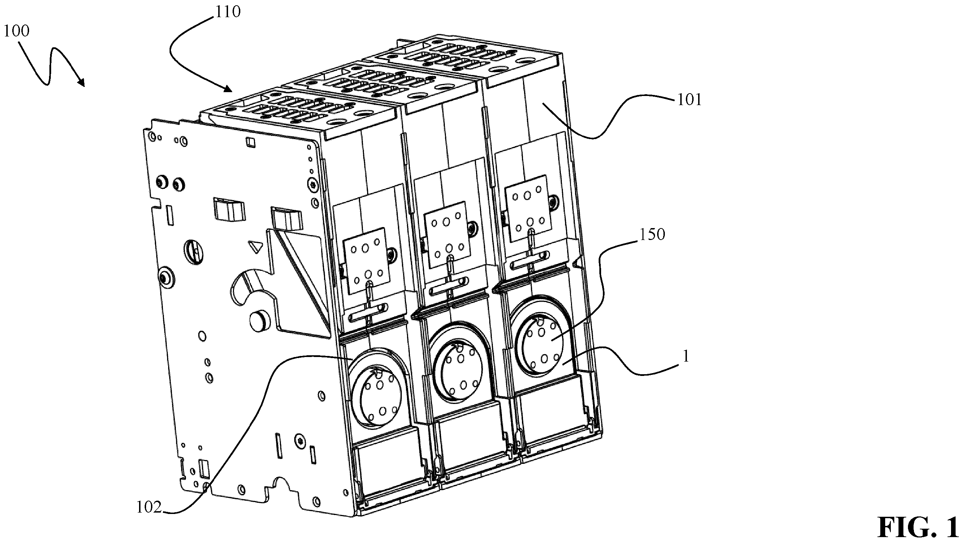

Figure 1 schematically shows a low-voltage circuit breaker 100 incorporating an accessory device 1 for each electric phase.

As it is possible to notice, each accessory device 1 is accommodated in a corresponding seat 102 of the outer casing 101 of the circuit breaker and, in operation, it is operatively coupled to a phase conductor 150 of the circuit breaker.

As mentioned above, each accessory device 1 is configured to provide a suitable power supply to feed a corresponding protection relay 110 installed on board the circuit breaker 100. In addition, each accessory device 1 is configured to provide the corresponding protection relay 110 with detection signals indicative of the current flowing along the corresponding phase conductor 150.

According to some embodiments of the invention, however, the accessory device 1 may be distinct from the switch 100 operatively associated thereto and it may be arranged as a stand-alone device or be mounted on other supporting structures.

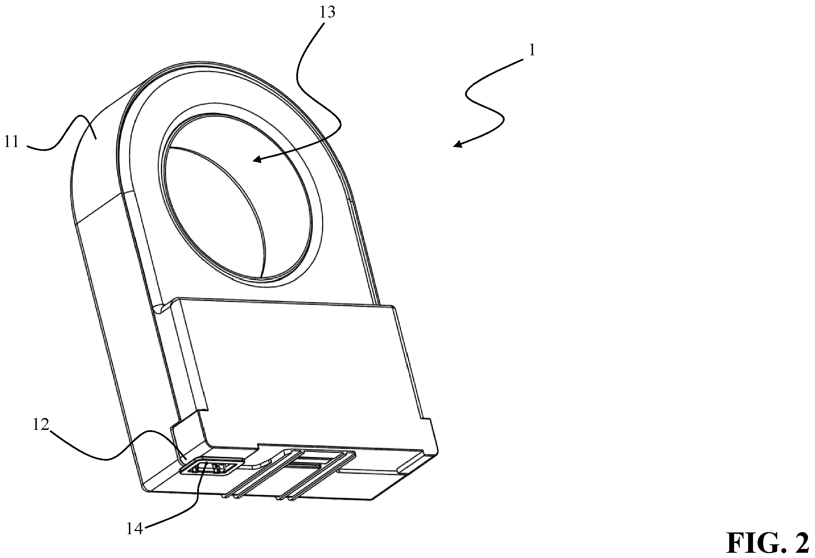

Figure 2 schematically shows an outer view of the accessory device 1.

The accessory device 1 preferably comprises an outer casing 11 conveniently made of an electrically insulating material.

The outer casing 11 preferably comprises a pass-through hole 13 for the passage of the electric conductor 150 (figure 1) intended to be operatively coupled to the accessory device.

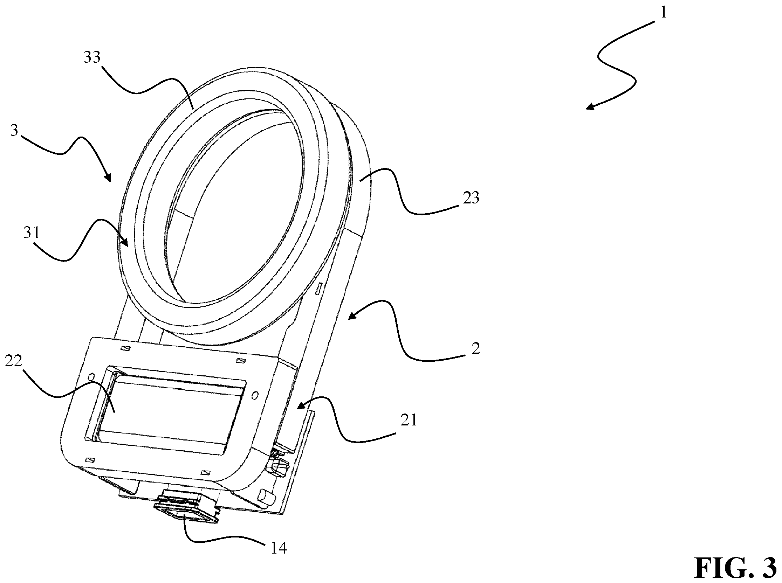

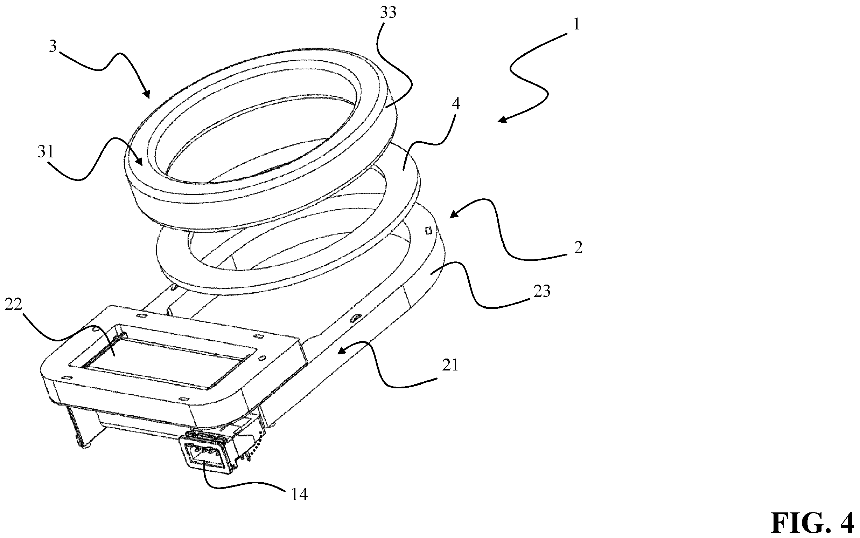

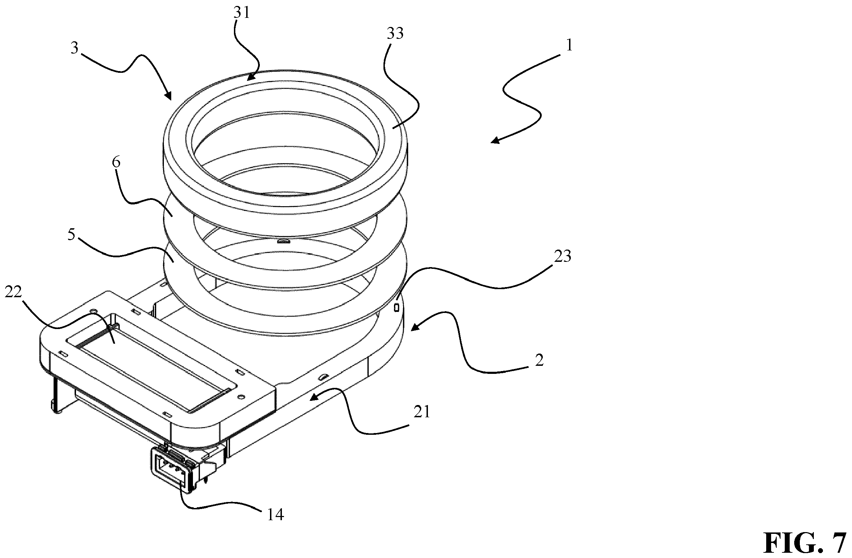

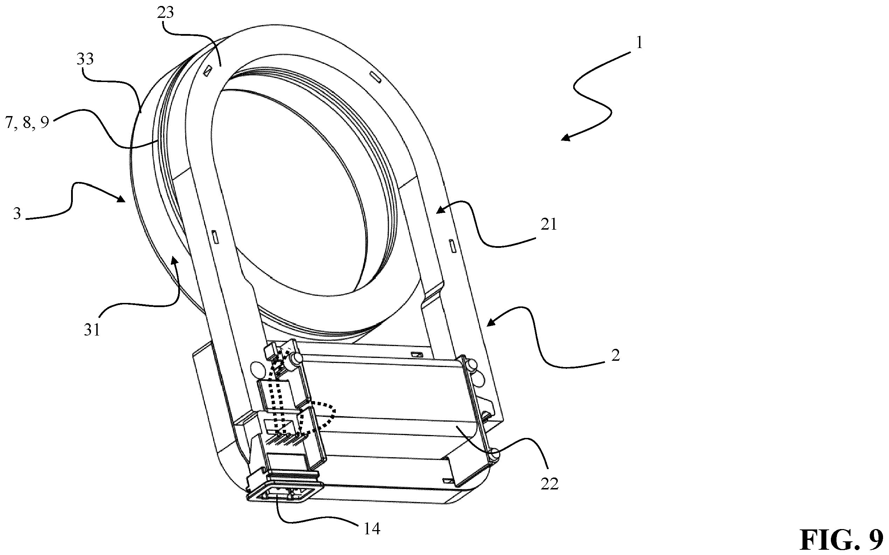

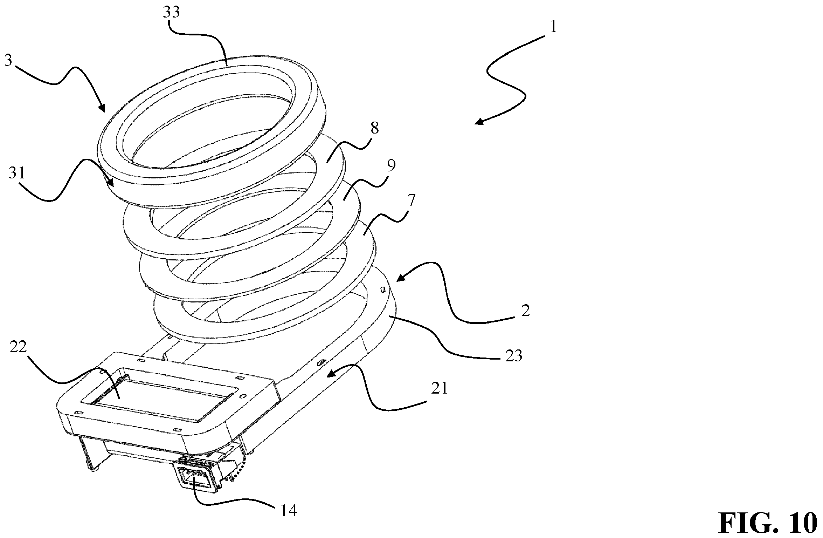

The outer casing 11 further comprises an additional aperture 12, at which an output port 14 of the accessory device 1 is arranged. Conveniently the output port 14 comprises first output pins (not shown) to output the above-mentioned power supply and second output pins (not shown) to output the above-mentioned detection signals. Preferably, the outer casing 11 may be made up of two half-parts, which can be coupled to one another through suitable fitting means. As an alternative, the outer casing 11 may be co-molded with some components of the accessory device. Referring now to figures 3-10, the accessory device 1 comprises a power supply arrangement 2 electrically connected to the electronic device 110 and adapted to feed said electronic device.

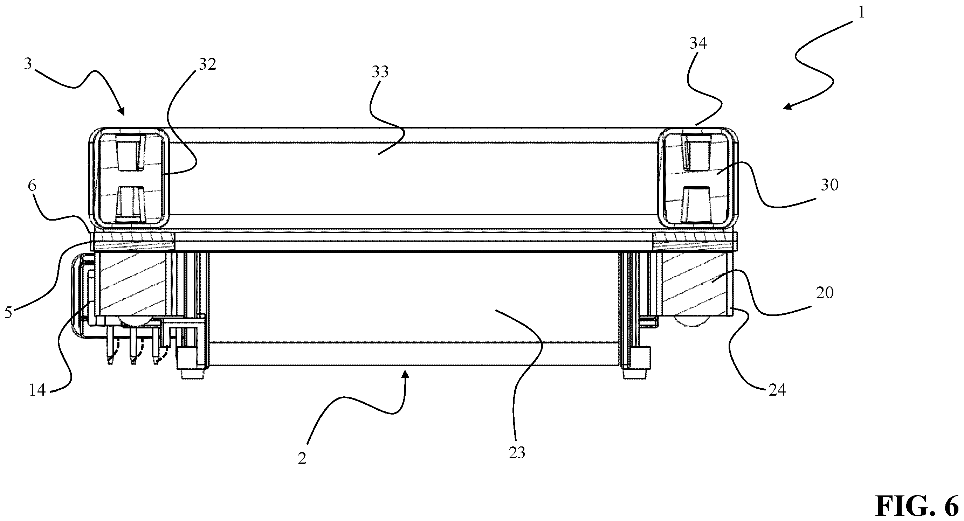

The power supply arrangement 2 includes a magnetic core 20 conveniently made of a ferromagnetic material (figure 6).

The magnetic core 20 forms a first magnetic circuit 21 configured to surround at least partially a primary winding conductor 150 (figure 1 - not shown in figures 3-10) in such a way to be enchained with this latter.

For the sake of clarity, it is specified that, for the purposes of the present invention, the term "magnetic circuit" has to be intended as a geometric path along which a magnetic flux (generated by a current flowing along the primary winding conductor 150) is induced to flow.

Preferably, the first magnetic circuit 21 is configured to develop substantially along a first reference plane perpendicular to the primary winding conductor 150.

Preferably, the first magnetic circuit 21 is configured to form a closed loop around the primary winding conductor 150.

Normally, the primary winding conductor 150 is not part of the accessory device 1. As illustrated above, the primary winding conductor 150 is preferably formed by the electric conductor (e.g. a phase conductor) included in or operatively associated to the switch 100.

According to some embodiments of the invention (not shown), however, the above-mentioned primary winding conductor may be a piece of conductor fixed to the outer casing 11 of the accessory device 1 and electrically connectable in series to a conductor included in or operatively associated to the switch 100.

The power supply arrangement 2 additionally includes a first secondary winding conductor 22 wound around the magnetic core 20.

Preferably, the first secondary winding conductor 22 is at a suitable winding portion (not shown) of the magnetic core 20.

Conveniently, the first secondary winding conductor 22 has first winding terminals (not shown) electrically connected to the above-mentioned first output terminals (not shown) of the output port 14.

As it is possible to notice, the first power supply arrangement is basically configured as an amperometric transformer.

When a current flows along the primary winding conductor 150, electric signals (namely current signals) are generated at the first winding terminals of the first secondary winding conductor 22. Such electric signals are made available to the output port 14 and form a power supply suitable for feeding the electronic device 110. In general, the power supply arrangement 2 may be realized at industrial level according to solutions of known type. For this reason, hereinafter, it will be described only in relation to the aspects of interest of the present invention, for the sake of brevity.

According to the invention, the accessory device 1 comprises a current detection arrangement 3 in combination with the above-illustrated power supply arrangement 2. The current detection arrangement 3 is adapted to provide detection signals indicative of a current flowing along the primary conductor 150.

Preferably, the current detection arrangement 3 is electrically connected to the electronic device 110 and provides such detection signals directly to said electronic device.

The current detection arrangement 3 is arranged next to the magnetic core 20 at least along a first portion 23 of this latter, which is configured to surround at least partially the primary winding conductor 150.

According to the embodiments of the invention shown in the cited figures, the current detection arrangement 3 includes a non-magnetic core 30 forming a second magnetic circuit 31 configured to be enchained with the primary winding conductor 150. Preferably, the second magnetic circuit 31 is configured to develop substantially along a second reference plane perpendicular to the primary winding conductor 150. Preferably, the second magnetic circuit 31 is configured to form a closed loop around the primary winding conductor 150.

The current detection arrangement 3 additionally includes a second secondary winding conductor 32 wound around the non-magnetic core 30 (figure 6).

Preferably, the second secondary winding conductor 32 is distributed along most of the length of the non-magnetic core 30.

Conveniently, the second secondary winding conductor 32 has second winding terminals (not shown) electrically connected to the above-mentioned second output terminals (not shown) of the output port 14.

As it is possible to notice, according to these embodiments of the invention, the current detection arrangement 3 is basically configured as a Rogowski coil. When a current flows along the primary winding conductor 150, electric signals (namely current signals) are generated at the second winding terminals of the second secondary winding conductor 32. Such electric signals are made available to the output port 14 and form detection signals indicative of the current flowing along the primary winding conductor 150

According to the above-mentioned embodiments of the invention, the magnetic core 20 and the non-magnetic core 30 are arranged next each other.

More precisely, the magnetic core 20 and the non-magnetic core 30 comprise respectively at least a first portion 23 and a second portion 33 arranged next to each other, preferably along parallel reference planes.

Conveniently, both the first portion 23 of magnetic core and the second portion 33 of non-magnetic core are configured to surround partially the primary conductor 150. Preferably, the first portion 23 of magnetic core and the second portion 33 of non-magnetic core are arranged one upon the other, in mutual neighboring positions. Preferably, the first portion 23 of magnetic core and the second portion 33 of non-magnetic core have matching shapes. More preferably, they are configured as ring portions having approximately a same radius of curvature.

According to these embodiments of the invention, the current detection arrangement 3 comprises a casing 34 made of electrically insulating material (figure 6) and enclosing, at least partially, the non-magnetic core 30 and the second secondary winding conductor 32.

According to other embodiments of the invention (not shown in the cited figures), the current detection arrangement 3 may instead include one or more Hall sensors and positioned in proximity of the magnetic core 20 of the power supply arrangement 2, at least along the first portion 23 of said magnetic core. Preferably, these Hall sensors are arranged on a suitable insulating support and enclosed by a suitable protection casing.

In general, the current detection arrangement 3 may be realized at industrial level according to solutions of known type. For this reason, hereinafter, it will be described only in relation to the aspects of interest of the present invention, for the sake of brevity.

According to the invention, the accessory device 1 comprises one or more magnetic shield elements 4, 5, 6, 7, 8, 9 interposed, at least partially, between the magnetic core 20 of the power supply arrangement 2 and the current detection arrangement 3. Preferably, when the current detection arrangement 3 comprises a non-magnetic core 30, the one or more magnetic shield elements 4, 5, 6, 7, 8, 9 are interposed, at least partially, between the magnetic core 20 and the non-magnetic core 30.

More preferably, the one or more magnetic shield elements 4, 5, 6, 7, 8, 9 are interposed, at least partially, between the first portion 23 of magnetic core and the second portion 33 of non-magnetic core.

### EMBODIMENT #1

According to an embodiment of the invention (figures 3-4), the accessory device 1 comprises a single magnetic shield element 4 made of magnetic material, more preferably ferromagnetic material.

The magnetic shield element 4 extends along a corresponding reference plane parallel to the extension planes of the magnetic core 20 and the non-magnetic core 30.

The magnetic shield element 4 is interposed between the magnetic core 20 and the non-magnetic core 30, more particularly between the first portion 23 of magnetic core and the second portion 33 of non-magnetic core.

The magnetic shield element 4 has opposite surfaces in contact respectively with corresponding surfaces of the magnetic core 20 and of the casing 34 of the non-magnetic core 30.

The magnetic shield element 4 has a shape partially matching with the shapes of the first portion 23 of magnetic core and the shape of the second portion 33 of non-magnetic core. More particularly, the magnetic shield element 4 has a ring shape approximately with a same radius of curvature of the first portion 23 of magnetic core and the second portion 33 of non-magnetic core.

The magnetic shield element 4 may be bonded to the magnetic core 20 and to the casing 34 of the non-magnetic core 30. As an alternative, it may be simply sandwiched between the magnetic core 20 and the casing 34 of the non-magnetic core 30. In this case, the magnetic shield element 4 may be kept in position by the outer casing 11 of the accessory device.

### EMBODIMENT #2

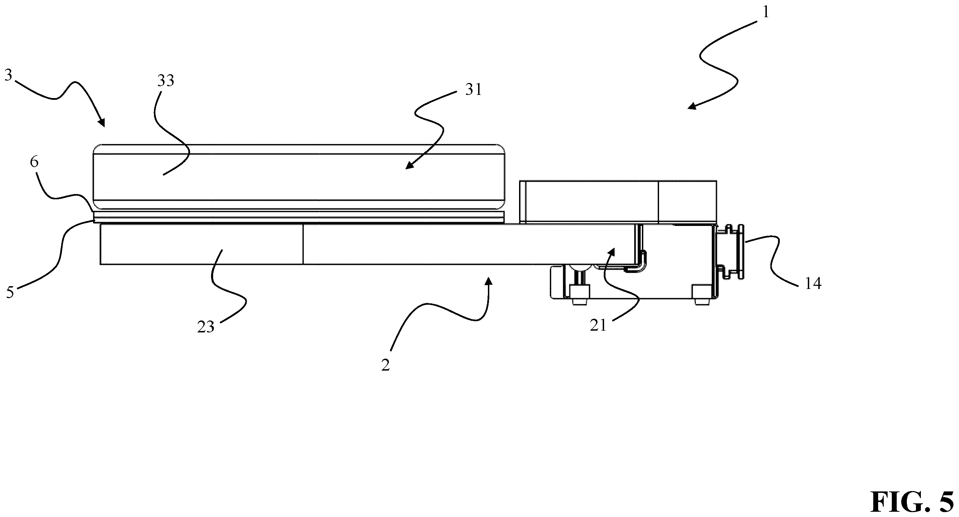

According to another embodiment of the invention (figures 5-7), the accessory device 1 comprises a pair of magnetic shield elements 5, 6 interposed between the magnetic core 20 and the non-magnetic core 30, more particularly between the first portion 23 of magnetic core and the second portion 33 of non-magnetic core.

The accessory device 1 comprises a first magnetic shield element 5, which is made of non-magnetic material and arranged in proximal position to the magnetic core 20, more particularly to first portion 23 of magnetic core.

The accessory device 1 further comprises a second magnetic shield element 6, which is made of magnetic material and arranged in proximal position to the non-magnetic core 30, more particularly to second portion 33 of non-magnetic core.

The first magnetic shield element 5 may be made of plastic or silicone material while the second magnetic shield element 6 may be made of ferromagnetic material.

The magnetic shield elements 5, 6 are conveniently stacked one on another.

The first magnetic shield element 5 has opposite surfaces in contact respectively with corresponding surfaces of the magnetic core 20 and of the second magnetic shield element 6.

The second magnetic shield element 6 has opposite surfaces in contact respectively with corresponding surfaces of the first magnetic shield element 5 and of the second casing 34 of the non-magnetic core 30.

The first and second magnetic shield elements 5, 6 have shapes partially matching with the shapes of the first portion 23 of magnetic core and the shape of the second portion 33 of non-magnetic core 30. More particularly, the first and second magnetic shield elements 5, 6 have ring shapes approximately with a same radius of curvature of the first portion 23 of magnetic core and the second portion 33 of non-magnetic core 30.

The first and second magnetic shield elements 5, 6 may be bonded one to another, to the magnetic core 20 and to the casing 34 of the non-magnetic core 30. As an alternative, they may be simply sandwiched between the magnetic core 20 and the casing 34 of the non-magnetic core 30. In this case, the magnetic shield element 4 may be kept in position by the outer casing 11 of the accessory device.

### EMBODIMENT #3

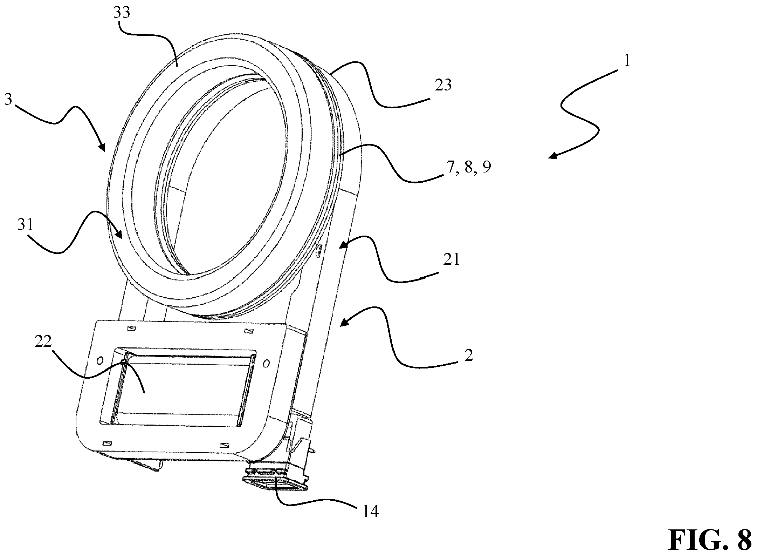

According to another embodiment of the invention (figures 8-10), the accessory device 1 comprises three magnetic shield elements 7, 8, 9 interposed between the magnetic core 20 and the non-magnetic core 30, more particularly between the first portion 23 of magnetic core and the second portion 33 of non-magnetic core.

The accessory device 1 comprises a third magnetic shield element 7 and a fourth magnetic material 8, which are both made of magnetic material and arranged respectively in proximal position to the magnetic core 20, more particularly to first portion 23 of magnetic core, and to the non-magnetic core 30, more particularly to second portion 33 of non-magnetic core.

The accessory device 1 comprises a fifth magnetic shield element 9, which is made of non-magnetic material and is interposed between the third and fourth magnetic shield elements 7, 8.

The third and the fourth magnetic shield elements 7, 8 may be made of ferromagnetic material while the fifth magnetic shield element 9 is made of plastic or silicone material.

Conveniently, the magnetic shield elements 7, 8, 9 are stacked one on another.

The third magnetic shield element 7 has opposite surfaces in contact respectively with corresponding surfaces of the magnetic core 20 and of the fifth magnetic shield element 9.

The fourth magnetic shield element 8 has opposite surfaces in contact respectively with corresponding surfaces of the fifth magnetic shield element 9 and of the second casing 34 enclosing the non-magnetic core 30.

The fourth magnetic shield element 9 has opposite surfaces in contact respectively with corresponding surfaces third and fourth magnetic shield elements 7, 8.

The third, fourth and fifth magnetic shield elements 7, 8, 9 have shapes matching with the shapes of the first portion 23 of magnetic core and the shape of the second portion 33 of non-magnetic core 30. More particularly, the third, fourth and fifth magnetic shield elements 7, 8, 9 have ring shapes approximately with a same radius of curvature of the first portion 23 of magnetic core and the second portion 33 of non-magnetic core 30.

The third, fourth and fifth magnetic shield elements 7, 8, 9 may be bonded one to another, to the magnetic core 20 and to the casing 34 of the non-magnetic core 30. As an alternative, they may be simply sandwiched between the magnetic core 20 and the casing 34 of the non-magnetic core 30. In this case, the magnetic shield element 4 may be kept in position by the outer casing 11 of the accessory device.

The accessory device, according to the invention, provides remarkable advantages with respect to the known apparatuses of the state of the art.

The arrangement one or more magnetic shield elements 4, 5, 6, 7, 8, 9 between the magnetic core 20 of the power supply arrangement 2 and the current detection arrangement 3 (preferably the non-magnetic core 30 of this latter) allows reducing the magnetic flux leaking from the first magnetic circuit 21 and influencing the operation of the current detection arrangement 3, when a current flow along the primary conductor 150.

For example, referring to the embodiments shown in the cited figures, the one or more magnetic shield elements 4, 5, 6, 7, 8, 9 can remarkably reduce the magnetic flux leaking from the first magnetic circuit 21 of the power supply arrangement and directed in such a way to enchain with the second magnetic circuit 31 of the current detection arrangement, when a current flows along the primary winding conductor 150.

The solution provided by the present invention allows greatly improving the performances of the current detection arrangement 3 in comparison to traditional solutions of the state of the art.

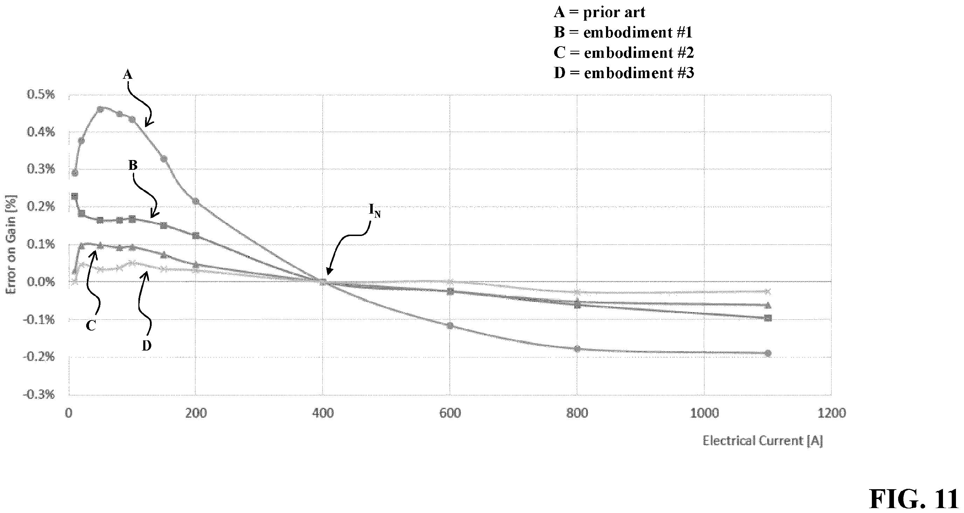

Figure 11 shows different error curves for current measurements carried out by an accessory device of the state of the art and by the accessory device of the invention, according to the different embodiments described above.

The error curves shown in figure 11 are all parametrized for reference current I_{N} = 400A, which is a typical nominal current for industrial circuit breakers.

As it is possible to notice, when realized according to any of the above-mentioned embodiments, the accessory device 1 ensures a noticeable increase of the measurement accuracy with respect to the traditional device, in particular when the measurement currents are far from the nominal current I_{N}.

In the accessory device, the measurement accuracy is quite stable for a wide range of current values. For example, when realized according to the embodiments #2 and #3 described above, the accessory device 1 ensures a measurement accuracy comprised in the range of [-0,1%, 0,1%] and substantially independent from the current magnitude.

The accessory device, according to the invention, has a relatively simple and compact structure and it can be easily incorporated in the overall structure of a low-voltage switch.

The accessory device, according to the invention, is relatively easy and cheap to manufacture at industrial level.

## Claims

1. An accessory device (1) for a low-voltage switch, said accessory device comprising:
- a power supply arrangement (2) for providing a power supply to feed an electronic device onboard said low-voltage switch, said power supply arrangement including a magnetic core (20), which forms a first magnetic circuit (21) configured to be enchained with a primary winding conductor (150), and a first secondary winding conductor (22), which is wound around said magnetic core;
- a current detection arrangement (3) for providing detection signals indicative of a current flowing along said primary conductor (150);
wherein said magnetic core (20) and said current detection arrangement (3) are arranged next to each other,
**characterized in that** said accessory device (1) comprises one or more magnetic shield elements (4, 5, 6, 7, 8, 9) interposed, at least partially, between said magnetic core (20) and said current detection arrangement (3).

2. Accessory device, according to claim 1, **characterized in that** said current detection arrangement (3) includes a non-magnetic core (30), which forms a second magnetic circuit (31) configured to be enchained with said primary winding conductor (150), and at least a second secondary winding conductor (32), which is wound around said non-magnetic core;
wherein said magnetic core (20) and said non-magnetic core (30) are arranged next to each other,
wherein said one or more magnetic shield elements (4, 5, 6, 7, 8, 9) are interposed, at least partially, between said magnetic core (20) and said non-magnetic core (30).

3. Accessory device, according to claim 2, **characterized in that** a first portion (23) of said magnetic core (20) and a second portion (33) of said non-magnetic core (30) are arranged next to each other,
wherein said one or more magnetic shield elements (4, 5, 6, 7, 8, 9) are interposed, at least partially, between said first portion (23) of said magnetic core (20) and said second portion (33) of said non-magnetic core (30).

4. Accessory device, according to one of the previous claims, **characterized in that** it includes a single magnetic shield element (4) made of magnetic material.

5. Accessory device, according to claim 4, **characterized in that** said single magnetic shield element (4) is made of ferromagnetic material.

6. Accessory device, according to one of the claims from 1 to 3, **characterized in that** it includes a first magnetic shield element (5) made of non-magnetic material and arranged in proximal position to said magnetic core (20) and a second magnetic shield element (6) made of magnetic material and arranged in proximal position to said current detection arrangement (3).

7. Accessory device, according to claim 6, **characterized in that** said first magnetic shield element (5) is made of plastic or silicone material and said second magnetic shield element (6) is made of ferromagnetic material.

8. Accessory device, according to one of the claims from 1 to 3, **characterized in that** it includes a third magnetic shield element (7) and a fourth magnetic shield element (8), which are made of magnetic material and are arranged in proximal position respectively to said magnetic core (20) and to said current detection arrangement (3), and a fifth magnetic shield element (9), which is made of non-magnetic material and is interposed between said third and fourth magnetic shield elements (7, 8).

9. Accessory device, according to claim 8, **characterized in that** said third and fourth magnetic shield elements (7, 8) are made of ferromagnetic material and said fifth magnetic shield element (9) is made of plastic or silicone material.

10. Accessory device, according to according to one of the previous claims, **characterized in that** said one or more magnetic shield elements (4, 5, 6, 7, 8, 9) have a ring shape.

11. Accessory device, according to according to one of the previous claims, **characterized in that** said one or more magnetic shield elements (4, 5, 6, 7, 8, 9) have shapes partially matching with the shape the first portion (23) of said magnetic core (20) and the shape of the second portion (33) of said non-magnetic core (20).

12. A low-voltage switch, **characterized in that** it comprises at least an accessory device (1), according to one of the previous claims.
